(19) **Europäisches Patentamt European Patent Office Office européen des brevets**

(11) **EP 4 764 537 A1**

(12) **EUROPEAN PATENT APPLICATION**
published in accordance with Art. 153(4) EPC

(43) Date of publication:
**24.06.2026 Bulletin 2026/26**

(21) Application number: **24897905.6**

(22) Date of filing: **28.10.2024**

(51) International Patent Classification (IPC):
**G01R 31/385** (2019.01)  **G01R 31/396** (2019.01)
**G01R 31/371** (2019.01)  **G16Y 40/10** (2020.01)

(52) Cooperative Patent Classification (CPC):
**G01R 31/371; G01R 31/385; G01R 31/396;
G16Y 40/10;** Y02E 60/10

(86) International application number:
**PCT/KR2024/016580**

(87) International publication number:
**WO 2025/116308 (05.06.2025 Gazette 2025/23)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **01.12.2023 KR 20230171978**

(71) Applicant: **LG Energy Solution, Ltd.
Seoul 07335 (KR)**

(72) Inventors:
• **PARK, Heon Il
Daejeon 34122 (KR)**

• **KWON, Jung Hyun
Daejeon 34122 (KR)**
• **LEE, Hee Sang
Daejeon 34122 (KR)**
• **CHO, Jun Hyung
Daejeon 34122 (KR)**
• **CHOI, Min Sook
Daejeon 34122 (KR)**
• **KANG, Hee Chul
Daejeon 34122 (KR)**
• **HWANG, Yun Son
Daejeon 34122 (KR)**

(74) Representative: **Plasseraud IP
104 Rue de Richelieu
CS92104
75080 Paris Cedex 02 (FR)**

(54) **DATA MANAGEMENT SYSTEM AND DATA MANAGEMENT METHOD**

(57)     According to some embodiments, a data management system includes a plurality of Internet of Things (IoT) configured to measure battery data from a plurality of battery modules and perform a reporting task for the battery data according to a data reporting policy, and a management server configured to diagnose states of the plurality of battery modules based on the battery data and adjust the data reporting policy based on the states of the plurality of battery modules and the result of the reporting task.

FIG.2

**Description**

**TECHNICAL FIELD**

CROSS-REFERENCE TO RELATED APPLICATION

This application claims priority to and the benefit of Korean Patent Application No. 10-2023-0171978 filed in the Korean Intellectual Property Office on December 1, 2023, the entire contents of which are incorporated herein by reference.

TECHNICAL FIELD

Embodiments disclosed herein relate to a data management system and data management method.

**BACKGROUND ART**

Recently, research and development on secondary batteries has been actively conducted. Here, the secondary battery is a battery capable of charging and discharging and may be construed as including all recent lithium ion batteries such as conventional Ni/Cd batteries and Ni/MH batteries. Among secondary batteries, lithium ion batteries may have a higher energy density than conventional Ni/Cd batteries, Ni/MH batteries, etc. and may be manufactured in a compact and lightweight manner, and thus may have high usability in terms of power sources for mobile devices. Recently, the lithium-ion batteries are attracting attention as a next-generation energy storage medium as a range of use expands to a power source for an electric vehicle.

When a battery module is manufactured, an Internet of Things (IoT) technology can be used to measure voltages, temperatures, and the like of cells included in a module and diagnose their states. A sensor attached to a battery module can measure battery data and transmit the measured battery data to a server via a wireless data network, and the server can diagnose the state of the module based on the battery data. In this case, module diagnosis can be hindered due to a time difference between the time of the sensor and the time of the server, a transmission failure of data reporting, and the like.

**DISCLOSURE**

**TECHNICAL PROBLEM**

Embodiment disclosed herein are directed to providing a data management system and a data management method, which are capable of adjusting a data reporting policy for a plurality of sensors so that state diagnosis can be smoothly performed through a sensor in a process of manufacturing a battery module.

Technical objects of embodiments disclosed herein are not limited to the above-described objects, and other objects not described will be able to be clearly understood by those skilled in the art from the following descriptions.

**TECHNICAL SOLUTION**

According to some embodiments, a data management system includes a plurality of Internet of Things (IoT) configured to measure battery data from a plurality of battery modules and perform a reporting task for the battery data according to a data reporting policy, and a management server configured to diagnose states of the plurality of battery modules based on the battery data and adjust the data reporting policy based on the states of the plurality of battery modules and the result of the reporting task.

According to some embodiments, each of the plurality of IoT sensors is configured to measure open circuit voltage (OCV) values from a plurality of battery cells of a corresponding battery module among the plurality of battery modules, and the management server is configured to diagnose whether a low voltage abnormality occurs in the plurality of battery cells based on the OCV values.

According to some embodiments, the data reporting policy includes a synchronization policy for a reporting time of the reporting task, and the management server is configured to modify the synchronization policy based on a difference between an actual reporting time of each of the plurality of IoT sensors and a reference reporting time.

According to some embodiments, the reference reporting time is a time at which diagnosis of the low voltage diagnosis is performed in a current cycle, the management server is configured to transmit a negative response to a first IoT sensor when the actual reporting time of the first IoT sensor among the plurality of IoT sensors is earlier than the reference reporting time, and the first IoT sensor is configured to retransmit the OCV values in the next cycle based on the negative response.

According to some embodiments, the management server is configured to diagnose the low voltage abnormality of the battery module corresponding to the OCV values retransmitted in the next cycle more preferentially than low voltage abnormalities of other battery modules due to the negative response.

According to some embodiments, the data reporting policy includes a retransmission policy for a retransmission failure of the reporting task, the plurality of IoT sensors are configured to attempt retransmission of the battery data according to the retransmission policy when the reporting task is not successful, and the management server is configured to modify the retransmission policy based on retransmission attempt counts of the plurality of IoT sensors.

According to some embodiments, the management server is configured to determine an error count of each of the plurality of IoT sensors based on an execution state of the reporting task, and generate a list of defects for the plurality of IoT sensors based on the error count.

According to some embodiments, each of the plurality of IoT sensors is attached to a corresponding battery module among the plurality of battery modules and is configured to be operated by power provided from the corresponding battery module, and the management server is configured to provide the list of defects to an operator terminal of an operator who manages state diagnosis of the plurality of battery modules.

According to some embodiments, a data management method includes measuring battery data from a plurality of battery modules through a plurality of Internet of Things (IoT) sensors, performing a reporting policy for the battery data according to a data reporting policy through the plurality of IoT sensors, diagnosing states of the plurality of battery modules based on the battery data through a management server, and adjusting the data reporting policy based on the states of the plurality of battery modules and the result of the reporting task through the management server.

According to some embodiments, the measuring of the battery data includes measuring open circuit voltage (OCV) values from a plurality of battery cells of a corresponding battery module among the plurality of battery modules through each of the plurality of IoT sensors, and the diagnosing of the states of the plurality of battery modules includes diagnosing whether a low voltage abnormality occurs in the plurality of battery cells based on the OCV values through the management server.

According to some embodiments, the data reporting policy includes a synchronization policy for a reporting time of the reporting task, and the adjusting of the data reporting policy includes modifying the synchronization policy based on a difference between an actual reporting time of each of the plurality of IoT sensors and a reference reporting time.

According to some embodiments, the reference reporting time is a time at which diagnosis of the low voltage diagnosis is performed in a current cycle, and the modifying of the synchronization policy includes transmitting a negative response to a first IoT sensor when the actual reporting time of the first IoT sensor among the plurality of IoT sensors is earlier than the reference reporting time through the management server, and retransmitting the OCV values in the next cycle based on the negative response through the first IoT sensor.

According to some embodiments, the data management method further includes diagnosing the low voltage abnormality of the battery module corresponding to the OCV values retransmitted in the next cycle more preferentially than low voltage abnormalities of other battery modules due to the negative response through the management server.

According to some embodiments, the data reporting policy includes a retransmission policy for a retransmission failure of the reporting task, the modifying of the synchronization policy includes attempting retransmission of the battery data according to the retransmission policy when the reporting task is not successful through the plurality of IoT sensors, and modifying the retransmission policy based on retransmission attempt counts of the plurality of IoT sensors through the management server.

According to some embodiments, the data management method further includes determining an error count of each of the plurality of IoT sensors based on an execution state of the reporting task through the management server, and generating a list of defects for the plurality of IoT sensors based on an error count through the management server.

According to some embodiments, each of the plurality of IoT sensors is attached to a corresponding battery module among the plurality of battery modules and is configured to be operated by power provided from the corresponding battery module, and the list of defects are provided to an operator terminal of an operator who manages state diagnosis of the plurality of battery modules.

## ADVANTAGEOUS EFFECTS

According to the embodiment disclosed herein, thereby can be provided a data management system and a data management method, which are capable of adjusting the data reporting policy for the plurality of sensors so that state diagnosis can be smoothly performed through the sensor in the process of manufacturing a battery module.

Technical effects according to the embodiments disclosed herein are not limited to the above-described effects, and other effects not described will be able to be clearly understood by those skilled in the art according to the disclosure of the present document.

## DESCRIPTION OF DRAWINGS

FIG. 1 shows a process of operating a data management system according to some embodiments.

FIG. 2 shows a structure for diagnosing states of a plurality of battery modules according to some embodiments.

FIG. 3 shows elements constituting the data management system according to some embodiments.

FIG. 4 shows a detailed type of a data reporting policy according to some embodiments.

FIG. 5 shows a method of operating an Internet of Things (IoT) sensor according to a synchronization policy and a retransmission policy according to some embodiments.

FIG. 6 shows operations constituting a data management method according to some embodiments.

## MODE FOR INVENTION

Hereinafter, embodiments disclosed herein will be described with reference to the accompanying drawings. However, it should be understood that this is not intended to limit the disclosure of the present document to specific embodiments and includes various modifications, equivalents, and/or alternatives of the embodiments described herein.

It should be understood that the embodiments of the present document and the terms used herein are not intended to limit the technical features described herein to specific embodiments and include various modifications, equivalents, or substitutes of the corresponding embodiments. In the description of the drawings, similar reference numerals may be used for similar or related components. The singular form of a noun corresponding to an item may include one item or a plurality of items unless the relevant context clearly dictates otherwise.

In the present document, each of phrases such as "A or B," "at least one of A and B," "at least one of A or B," "A, B, or C," "at least one of A, B, and C," and "at least one of A, B, or C" may include any one of the items listed together in the corresponding phrase among these phrases or all possible combinations thereof. Terms such as "first," "second," "first," "second," "A," "B," "(a)," or "(b)" may simply be used to distinguish the corresponding component from another and do not limit the corresponding components in another aspect (e.g., importance or order).

In the present document, when a certain (e.g., a first) component is described as being "coupled," "connected," or "joined" to another (e.g., a second) component with or without the terms "functionally" or "communicatively" or "coupled" or "connected," this means that the certain component may be connected to another component directly (e.g., in a wired or wireless manner) or indirectly (e.g., through a third component).

A method according to various embodiments disclosed herein may be provided by being included in a computer program product. The computer program product may be traded between sellers and buyers as commodities. The computer program product may be distributed in the form of a device-readable storage medium (e.g., a compact disc read only memory (CD-ROM)) or distributed (e.g., downloaded or uploaded) through application stores or directly online between two user devices. In the case of the online distribution, at least some of the computer program products may be at least temporarily stored or temporarily generated in a device-readable storage medium such as a memory of a server of a manufacturer, a server of an application store, or a relay server.

According to the embodiments disclosed herein, each component (e.g., a module or program) of the above-described components may include a single object or a plurality of objects, and some of the plurality of objects may be separately disposed in another component. According to the embodiments disclosed herein, one or more of the above-described corresponding components or operations may be omitted, or one or more other components or operations may be added. Alternatively or additionally, the plurality of components (e.g., modules or programs) may be integrated into one component. In this case, the integrated component may perform one or more functions of each of the plurality of components identically or similarly to those performed by the corresponding component of the plurality of components before the integration. According to the embodiments disclosed herein, operations performed by modules, programs, or other components may be executed sequentially, in parallel, repeatedly, or heuristically, or one or more of the operations may be executed in a different order or omitted, or one or more other operations may be added.

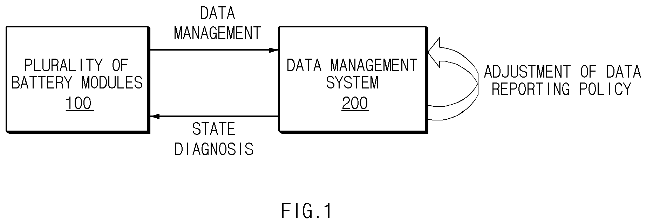

FIG. 1 shows a process of operating a data management system according to some embodiments.

Referring to FIG. 1, a data management system 200 may collect battery data from a plurality of battery modules 100 and perform policy adjustment on state diagnosis for a plurality of battery modules 100 based on the battery data and reporting of the battery data.

The data management system 200 may include a system for managing a transmission/reception and/or reporting procedure of data required to diagnose the states of the plurality of battery modules 100 in a process of manufacturing the plurality of battery modules 100. The data management system 200 may collect battery data on the plurality of battery modules 100 based on the data reporting policy and modify the data reporting policy according to the collection state of the battery data.

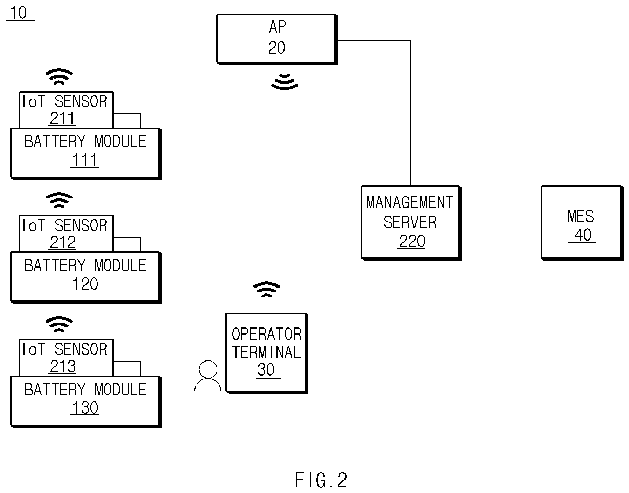

FIG. 2 shows a structure for diagnosing states of a plurality of battery modules according to some embodiments.

Referring to FIG. 2, a structure 10 for diagnosing the states of the plurality of battery modules may include a plurality of battery modules 110, 120, 130, ..., a plurality of Internet of Things (IoT) sensors 211, 212, 213, ..., a management server 220, an access point (AP) 20, an operator terminal 30, and a manufacturing execution system (MES) 40.

Various IoT technologies may be used to implement a smart factory. In the process of manufacturing the plurality of battery modules 100, the plurality of IoT sensors 210 may be used for state diagnosis. Each IoT sensor may have its own processing function and periodically collect and provide a voltage, temperature, state of charge (SOC), and state of health (SOH) of a battery cell to a management server 220.

The plurality of IoT sensors 210 may communicate with the management server 220 in a wireless communication manner through the AP 20. The management server 220 and the MES 40 may determine that the plurality of battery modules 100 are defective based on battery data collected through the plurality of IoT sensors 210. However, when the data collection procedure is not performed smoothly, the efficiency and accuracy of defect determination can be deteriorated. For example, a data reporting problem may occur due to loss of communication packets, poor time synchronization between a sensor and a server, a limitation of the sensor that cannot communicate in both directions, and the like. To solve such a problem, the data management system 200 may adjust the data reporting policy.

The management server 220 may integrate data provided from the plurality of IoT sensors 210. The management server 220 may transmit the integrated data to the MES 40. The MES 40 may perform various management functions related to the manufacturing of the plurality of battery modules 100. To this end, data monitoring, tracking, control, and the like may be performed. The AP 20 may provide a wired/wireless communication network between the plurality of IoT sensors 210, the management server 220, and the operator terminal 30. For example, the AP 20 may be implemented in the form of a WLAN or Wi-fi.

The operator terminal 30 may be a terminal of an operator who manages a state diagnosis process in a production line of the plurality of battery modules 100. The data management system 200 may select a defective sensor among the plurality of IoT sensors 210 based on data reporting states of the plurality of battery modules 100 and provide the selected defective sensor to the operator terminal 30. The operator may check the defective sensor through the operator terminal 30 and replace the defective sensor with another sensor.

The plurality of IoT sensors 210 may be attached to the plurality of battery modules 100. Each IoT sensor may periodically measure data such as a voltage, a current, and a temperature from a corresponding battery module and derive battery data such as an open circuit voltage (OCV), an SOC, and an SOH. The plurality of IoT sensors 210 may operate based on power provided from the plurality of battery modules 100. To reduce power loss, the plurality of IoT sensors 210 may periodically wake up to perform a data reporting task and then re-enter a sleep state.

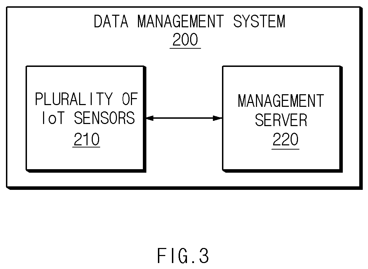

FIG. 3 shows elements constituting the data management system according to some embodiments.

Referring to FIG. 3, the data management system 200 may include the plurality of IoT sensors 210 and the management server 220. However, the embodiments are not limited thereto, and some components may be omitted from the data management system 200, or other general-purpose components may be further included in the data management system 200.

The plurality of IoT sensors 210 may include a communication module for communicating with the management server 220 through the AP 20, a processing module for inquiring a data reporting policy and performing a data collection operation by adopting the inquired data reporting policy, and the like. Since the plurality of IoT sensors 210 perform a reporting task using the power of the plurality of battery modules 100 and then re-enter the sleep state, one-way communication may be performed in relation to the management server 220.

The management server 220 may include a memory and a processor. A processor of the management server 220 may be implemented in at least one of a microprocessor, a CPU, a GPU, and an AP. For example, the memory of the management server 220 may be implemented as a non-volatile device such as a ROM, a PROM, an EPROM, an EEPROM, a flash memory, a PRAM, an MRAM, a RRAM, or an FRAM, or a volatile device such as a an SRAM, an SDRAM, or a PRAM, and implemented in the form of an HDD, an SSD, an SD, a Micro-SD, or a combination thereof. The processor may process necessary operations by executing various data, instructions, software, mobile applications, computer programs, and the like stored in the memory.

The plurality of IoT sensors 210 may be configured to measure battery data from the plurality of battery modules 100. Each IoT sensor may measure voltages, currents, temperatures, and the like from the plurality of battery cells of the corresponding battery module and based on this, estimate SOCs, SOHs, and the like thereof. The battery data may include OCV data.

The plurality of IoT sensors 210 may be configured to perform a reporting task on battery data according to a data reporting policy. The data reporting policy may include rules, recommendations, limitations, and the like observed for reporting battery data about the plurality of battery modules 100 to the management server 220. The data reporting policy may be changed depending on operating states of the plurality of IoT sensors 210. The plurality of IoT sensors 210 may inquire a current state of the data reporting policy to report battery data.

The management server 220 may be configured to diagnose the states of the plurality of battery modules 100 based on the battery data. For example, the state of the corresponding battery module may be diagnosed based on OCV values of a plurality of battery cells of each battery module. OCV deviation values may be calculated based on a difference between the OCV values and an OCV average value, and defects such as a low voltage of each battery module may be diagnosed through various processing processes on the OCV deviation values. According to an embodiment, instead of the management server 220, the MES 40 may be configured to diagnose the states of the plurality of battery modules 100.

The management server 220 may be configured to adjust the data reporting policy based on the states of the plurality of battery modules 100 and the result of the reporting task. The result of the reporting task may be determined according to whether the management server 220 smoothly receives the battery data provided from the plurality of IoT sensors 210. When the result of the reporting task is poor, the data reporting policy may be adjusted to solve such a problem. Meanwhile, when the states of the plurality of battery modules 100 are poor, the data reporting policy may be modified more strictly to perform defect diagnosis more thoroughly.

According to an embodiment, each of the plurality of IoT sensors 210 may be configured to measure OCV values from the plurality of battery cells of the corresponding battery module among the plurality of battery modules 100, and the management server 220 may be configured to diagnose whether a low voltage abnormality occurs in the plurality of battery cells based on the OCV values. For example, the low voltage abnormality may be determined based on deviation values of the OCV values with respect to an average value in each battery module. Meanwhile, other types of battery data other than the OCV values may be used, and other indicators such as lithium deposition or increased internal resistance may be analyzed in addition to the low voltage abnormality.

According to an embodiment, the data reporting policy may include a synchronization policy about the reporting time of the reporting task, and the management server 220 may be configured to modify the synchronization policy based on a difference between an actual reporting time and a reference reporting time of each of the plurality of IoT sensors 210. As the plurality of IoT sensors 210 operate, a time difference may occur for each sensor, and when such a difference is accumulated, a deviation in reporting time for each sensor may increase from the perspective of the management server 220. When the deviation of the reporting time for each sensor increases, the performance of diagnosing defects such as a low voltage abnormality can be deteriorated. To reduce such a reporting time deviation, the plurality of IoT sensors 210 may be synchronized by modifying the synchronization policy.

According to an embodiment, the reference reporting time may be a time when the diagnosis of the low voltage abnormality is performed in a current cycle, the management server 220 may be configured to transmit a negative response to a first IoT sensor when an actual reporting time of the first IoT sensor among the plurality of IoT sensors 210 is earlier than the reference reporting time, and the first IoT sensor may be configured to retransmit OCV values in the next cycle based on the negative response. When the data of the first IoT sensor is additionally reported at the time of the low voltage diagnosis, cycle-specific diagnosis data may be mixed. To prevent this, when the actual reporting is made before the reference report time, a negative response may be provided to the corresponding IoT sensor. The IoT sensor receiving the negative response may re-report data reported earlier. According to an embodiment, the negative response may be configured to be provided when the actual reporting time is earlier than the reference reporting time.

According to an embodiment, the management server 220 may be configured to diagnose the low voltage abnormality of the battery module corresponding to OCV values retransmitted in the next cycle more preferentially than low voltage abnormalities of other battery modules due to the negative response. When the number of the plurality of battery modules 100 is 10, low voltage diagnosis may be performed 10 times, and diagnosis of the reported module may be performed first. However, when there is the retransmission of the negative response, the diagnosis of the retransmission module may be performed earlier than other modules. In such a manner, the diagnostic procedure may re-proceed in a normal order from the next cycle.

According to an embodiment, the data reporting policy may include a retransmission policy for a data transmission failure of a reporting task, the plurality of IoT sensors 210 may be configured to attempt to retransmit battery data according to the retransmission policy when the reporting task is not successful, and the management server 220 may be configured to modify the retransmission policy based on the retransmission attempts of the plurality of IoT sensors 210. For example, the retransmission policy may prescribe the maximum number of retransmission attempts as 12, 24, and other values, and each IoT sensor may attempt to retransmit battery data in the range of the maximum count. When each IoT sensor succeeds in retransmitting battery data before reaching the maximum count, each IoT sensor cannot attempt to retransmit battery data the remaining counts. Alternatively, each IoT sensor may attempt to retransmit battery data as much as the maximum count of retransmission policy regardless of whether retransmission is successful before reaching the maximum count. Meanwhile, the maximum count of the retransmission policy may be modified based on the number of times that the plurality of IoT sensors 210 attempt to retransmit battery data. For example, when three IoT sensors 211, 212, and 213 attempt to retransmit battery data 0, 2, and 6 times, respectively, the retransmission policy may be adjusted based on values of 0, 2, and 6.

According to an embodiment, the management server 220 may be configured to determine an error count of each of the plurality of IoT sensors 210 based on the execution state of the reporting task and generate a list of defects for the plurality of IoT sensors 210 based on the error count. The error count may start from zero and increase by 1, 2, or other values whenever there is a reason for an increase. According to an embodiment, the reason for increasing the error count may include sensor component errors, sensor reset, a connection failure to the AP 20, OCV measurement NG, a change in state machine order, a change in communication protocol order, retransmission due to poor reporting time synchronization, holding of a sleep state due to a failure of periodic wakeup, and the like. Meanwhile, when the reason for the increase does not occur during a specific cycle, the error count may decrease. When an accumulated value of the error count exceeds a threshold value, the corresponding IoT sensor may be blacklisted, and an operator may check an IoT sensor registered in the blacklist through the operator terminal 30.

According to an embodiment, each IoT sensor of the plurality of IoT sensors 210 may be attached to the corresponding battery module among the plurality of battery modules 100 to be operated by power provided from the corresponding battery module, and the management server 220 may be configured to provide a list of defects to the operator terminal 30 of the operator who manages the state diagnosis of the plurality of battery modules 100. The plurality of IoT sensors 210 may be operated by power of the plurality of battery modules 100 without their own power sources. Therefore, the plurality of IoT sensors 210 may periodically wake up for data collection and reporting and re-enter the sleep state after the operation is completed. Since the plurality of IoT sensors 210 re-enter the sleep state for power efficiency, communication between the plurality of IoT sensors 210 and the management server 220 may be analyzed as one-way communication rather than two-way communication. Meanwhile, the operator may check the blacklist (list of defects) through the operator terminal 30 and replace the IoT sensor determined to be defective.

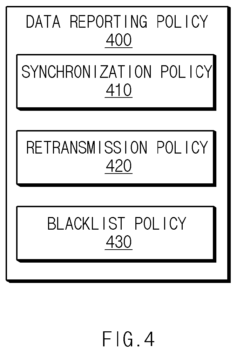

FIG. 4 shows a detailed type of a data reporting policy according to some embodiments.

Referring to FIG. 4, a data reporting policy 400 may include a synchronization policy 410, a retransmission policy 420, and a blacklist policy 430. In addition, other policies may be further prescribed to help smoothly collect battery data required for state diagnosis of the plurality of battery modules 100.

In the case of the synchronization policy 410, the plurality of IoT sensors 210 may report battery data to the management server 220, and the management server 220 may perform OCV low voltage determination at a specific time or transmit data necessary for OCV low voltage determination to the MES 40. In general, there may be differences in the times of the plurality of IoT sensors 210 by several minutes a day. In the case of a discharge process or the like that takes a relatively long time, accumulation of a time difference may affect a low voltage determination algorithm. In this regard, instead of performing time synchronization for the plurality of IoT sensors 210 each time, a method of providing an additional correction time to the reporting time of each IoT sensor may be used. That is, the synchronization policy 410 may include a policy for correcting the reporting time of each IoT sensor.

For example, when the reporting time of a specific IoT sensor Si is inappropriate, a value of the corresponding reporting time may be stored as quick_report_time. A difference between the quick_report_time and ocv_time as the reference reporting time may be stored as ocv_time_diff. When the additional correction time for the sensor Si is x, the maximum value of x may be specified as ocv_plus_time. The ocv_plus_time may be calculated as follows.

[Equation 1]

$$ocv\_plus\_time = \max(x, x - \frac{\frac{sum(ocv\_time\_diff)}{N\_negative\_response} - \max(ocv\_time\_diff)}{2})$$

In Equation 1, N_negative_response denotes the number of sensors receiving a negative response among the plurality of IoT sensors 210. sum(ocv_time_diff) denotes the sum of ocv_time_diff for the plurality of IoT sensors 210. max(ocv_time_diff) denotes the maximum value of ocv_time_diff for the plurality of IoT sensors 210. When the ocv_plus_time is calculated in this way, the reporting time of the sensor Si may be adjusted as much as the ocv_plus_time.

The retransmission policy 420 may cause the plurality of IoT sensors 210 to retransmit data reporting as much as a predetermined count when a negative response is received or a battery data reporting task is not successful. Since the communication with the management server 220 is one-way communication except for the negative response, the retransmission policy 420 may be introduced. For example, retransmission attempt count retry_count according to the retransmission policy 420 may be set to 12 or more and 24 or less in the following manner.

[Equation 2]

$$retry\_count = \min(24, 12 - \frac{max\_retransmission - min\_retransmission}{2})$$

In Equation 2, the upper limit value 24 and the lower limit value 12 may be changed to other values as needed. The maximum value of retransmission counts max_retransmission may be the maximum value of retransmission counts in the plurality of IoT sensors 210, and the minimum value of retransmission counts min_retransmission may be the minimum value of retransmission counts in the plurality of IoT sensors 210. For example, when the retransmission counts of the three IoT sensors 211, 212, and 213 are 0, 18, and 6, a retransmission attempt count retry_count according to the retransmission policy 420 may be set to min(24, 21)=21.

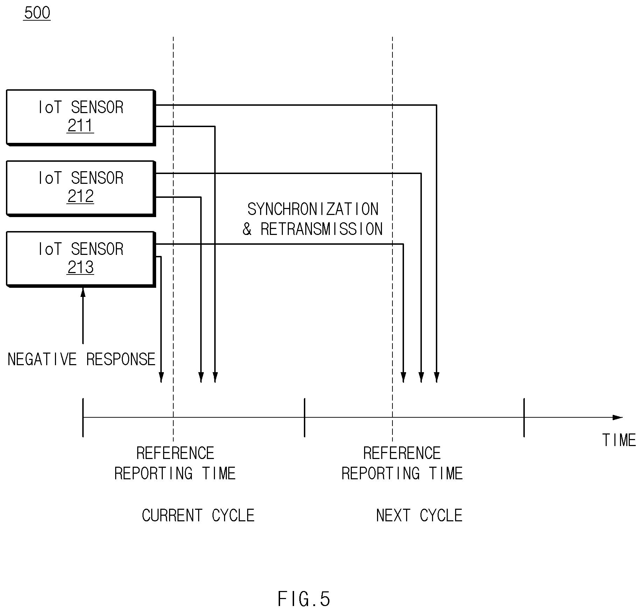

FIG. 5 shows a method of operating an Internet of Things (IoT) sensor according to a synchronization policy and a retransmission policy according to some embodiments.

Referring to FIG. 5, a graph 500 showing a method of operating an IoT sensor according to a synchronization policy and a retransmission policy may be shown.

In the graph 500, a reporting time of a third IoT sensor 213 may be earlier than the reference reporting time of the management server 220. In this regard, in the current cycle, the management server 220 may provide a negative response to the third IoT sensor 213. In response to the negative response, the third IoT sensor 213 may re-report data reported in the current cycle in the next cycle.

According to the synchronization policy, the reporting time of the third IoT sensor 213 may be adjusted. For example, in the same manner as Equation 1, an additional delay time may be applied to the reporting time of the third IoT sensor 213, and thus the reporting time of the third IoT sensor 213 may be later than the reference reporting time of the management server 220 from the next cycle.

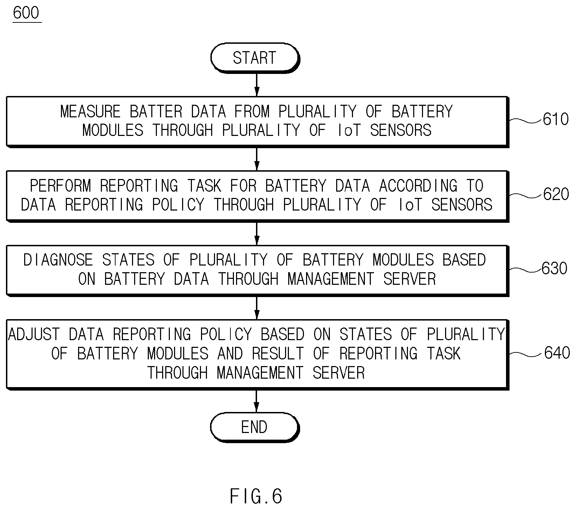

FIG. 6 shows operations constituting a data management method according to some embodiments.

Referring to FIG. 6, the data management method 600 may include operations 610 to 640. However, the embodiments are not limited thereto, and some operations may be omitted or general-purpose operations may be added, and operations of the data management method 600 may be executed in a different order from the shown order.

The data management method 600 may include operations processed in a time series in the data management system 200. Therefore, even when the contents are omitted below, the above-described contents for the data management system 200 may be applied to the data management method 600 in the same manner.

The operations 610 to 640 of the data management method 600 may be performed by the plurality of IoT sensors 210 and the management server 220 of the data management system 200.

In the operation 610, the data management system 200 may measure battery data from a plurality of battery modules through the plurality of IoT sensors.

In the operation 620, the data management system 200 may perform a reporting task on battery data according to the data reporting policy through the plurality of IoT sensors.

In the operation 630, the data management system 200 may diagnose states of the plurality of battery modules based on battery data through the management server.

In the operation 640, the data management system 200 may adjust the data reporting policy based on the states of the plurality of battery modules and the result of the reporting task through the management server.

According to an embodiment, the data management method 600 may be implemented in the form of a computer program stored in a computer-readable storage medium. That is, the computer program may include commands for implementing the data management method 600, and the commands of the program may be stored in the computer-readable storage medium. The computer program may include a mobile application.

According to an embodiment, the computer-readable recording medium may include magnetic media such as a hard disk, a floppy disk, and a magnetic tape, optical media such as a CD-ROM and a DVD, and magneto-optical media such as a floptical disk, and hardware devices specifically configured to store and execute program commands, such as a ROM, a RAM, and a flash memory. The computer program commands may include machine language code generated by a compiler and high-level language code that may be executed by a computer using an interpreter, etc.

The terms such as "comprise," "constitute," or "have" described above mean that the corresponding component may be inherent unless otherwise stated, and thus should be construed as further including another component rather than excluding another component. All terms including technical or scientific terms have the same meaning as commonly understood by those skilled in the art to which the embodiments disclosed herein pertain unless defined otherwise. Commonly used terms, such as terms defined in a dictionary, should be construed as consistent with the contextual meaning of the related art and are not construed in an ideal or excessively formal meaning unless explicitly defined herein.

The above description is merely the exemplary description of the technical spirit disclosed herein, and those skilled in the art to which embodiments disclosed herein pertain will be able to variously modify and change the present document without departing from the essential characteristics of the embodiments disclosed herein. Therefore, the embodiments disclosed herein are not intended to limit the technical spirit disclosed herein, but for illustrative purpose, and the scope of the technical spirit disclosed herein is not limited by these embodiments. The scope of the technical spirit disclosed herein should be construed by the appended claims, and all technical spirits within the equivalent range should be construed as being included in the scope of the present document.

**EP 4 764 537 A1**

[DESCRIPTION OF DRAWING SYMBOLS]

| | | | |
|---|---|---|---|
| 100: | a plurality of battery modules | 200: | data management system |
| 210: | a plurality of IoT sensors | 220: | management server |
| 600: | data management method | | |

**Claims**

1. A data management system comprising:

   a plurality of Internet of Things (IoT) configured to measure battery data from a plurality of battery modules and perform a reporting task for the battery data according to a data reporting policy; and
   a management server configured to diagnose states of the plurality of battery modules based on the battery data and adjust the data reporting policy based on the states of the plurality of battery modules and the result of the reporting task.

2. The data management system of claim 1, wherein each of the plurality of IoT sensors is configured to measure open circuit voltage (OCV) values from a plurality of battery cells of a corresponding battery module among the plurality of battery modules, and
   the management server is configured to diagnose whether a low voltage abnormality occurs in the plurality of battery cells based on the OCV values.

3. The data management system of claim 2, wherein the data reporting policy includes a synchronization policy for a reporting time of the reporting task, and
   the management server is configured to modify the synchronization policy based on a difference between an actual reporting time of each of the plurality of IoT sensors and a reference reporting time.

4. The data management system of claim 3, wherein the reference reporting time is a time at which diagnosis of the low voltage diagnosis is performed in a current cycle,

   the management server is configured to transmit a negative response to a first IoT sensor when the actual reporting time of the first IoT sensor among the plurality of IoT sensors is earlier than the reference reporting time, and
   the first IoT sensor is configured to retransmit the OCV values in the next cycle based on the negative response.

5. The data management system of claim 4, wherein the management server is configured to diagnose the low voltage abnormality of the battery module corresponding to the OCV values retransmitted in the next cycle more preferentially than low voltage abnormalities of other battery modules due to the negative response.

6. The data management system of claim 1, wherein the data reporting policy includes a retransmission policy for a retransmission failure of the reporting task,

   the plurality of IoT sensors are configured to attempt retransmission of the battery data according to the retransmission policy when the reporting task is not successful, and
   the management server is configured to modify the retransmission policy based on retransmission attempt counts of the plurality of IoT sensors.

7. The data management system of claim 1, wherein the management server is configured to:

   determine an error count of each of the plurality of IoT sensors based on an execution state of the reporting task, and
   generate a list of defects for the plurality of IoT sensors based on the error count.

8. The data management system of claim 7, wherein each of the plurality of IoT sensors is attached to a corresponding battery module among the plurality of battery modules and is configured to be operated by power provided from the corresponding battery module, and

the management server is configured to provide the list of defects to an operator terminal of an operator who manages state diagnosis of the plurality of battery modules.

9. A data management method comprising:

measuring battery data from a plurality of battery modules through a plurality of Internet of Things (IoT) sensors;
performing a reporting policy for the battery data according to a data reporting policy through the plurality of IoT sensors;
diagnosing states of the plurality of battery modules based on the battery data through a management server; and
adjusting the data reporting policy based on the states of the plurality of battery modules and the result of the reporting task through the management server.

10. The data management method of claim 9, wherein the measuring of the battery data includes measuring open circuit voltage (OCV) values from a plurality of battery cells of a corresponding battery module among the plurality of battery modules through each of the plurality of IoT sensors, and

the diagnosing of the states of the plurality of battery modules includes diagnosing whether a low voltage abnormality occurs in the plurality of battery cells based on the OCV values through the management server.

11. The data management method of claim 10, wherein the data reporting policy includes a synchronization policy for a reporting time of the reporting task, and

the adjusting of the data reporting policy includes modifying the synchronization policy based on a difference between an actual reporting time of each of the plurality of IoT sensors and a reference reporting time.

12. The data management method of claim 11, wherein the reference reporting time is a time at which diagnosis of the low voltage diagnosis is performed in a current cycle, and

the modifying of the synchronization policy includes:

transmitting a negative response to a first IoT sensor when the actual reporting time of the first IoT sensor among the plurality of IoT sensors is earlier than the reference reporting time through the management server; and
retransmitting the OCV values in the next cycle based on the negative response through the first IoT sensor.

13. The data management method of claim 12, further comprising diagnosing the low voltage abnormality of the battery module corresponding to the OCV values retransmitted in the next cycle more preferentially than low voltage abnormalities of other battery modules due to the negative response through the management server.

14. The data management method of claim 9, wherein the data reporting policy includes a retransmission policy for a retransmission failure of the reporting task,

the modifying of the synchronization policy includes:

attempting retransmission of the battery data according to the retransmission policy when the reporting task is not successful through the plurality of IoT sensors; and
modifying the retransmission policy based on retransmission attempt counts of the plurality of IoT sensors through the management server.

15. The data management method of claim 9, further comprising:

determining an error count of each of the plurality of IoT sensors based on an execution state of the reporting task through the management server; and
generating a list of defects for the plurality of IoT sensors based on an error count through the management server.

16. The data management method of claim 15, wherein each of the plurality of IoT sensors is attached to a corresponding battery module among the plurality of battery modules and is configured to be operated by power provided from the corresponding battery module, and

the list of defects are provided to an operator terminal of an operator who manages state diagnosis of the plurality of battery modules.

DATA
MANAGEMENT

PLURALITY OF
BATTERY MODULES
100

DATA MANAGEMENT
SYSTEM
200

ADJUSTMENT OF DATA
REPORTING POLICY

STATE
DIAGNOSIS

FIG.1

10

AP
20

IoT SENSOR
211

BATTERY MODULE
111

IoT SENSOR
212

BATTERY MODULE
120

IoT SENSOR
213

BATTERY MODULE
130

OPERATOR
TERMINAL
30

MANAGEMENT
SERVER
220

MES
40

FIG.2

DATA MANAGEMENT SYSTEM
200

PLURALITY OF
IoT SENSORS
210

MANAGEMENT
SERVER
220

FIG.3

DATA REPORTING POLICY
400

SYNCHRONIZATION POLICY
410

RETRANSMISSION POLICY
420

BLACKLIST POLICY
430

FIG.4

500

IoT SENSOR
211

IoT SENSOR
212

IoT SENSOR
213

SYNCHRONIZATION
& RETRANSMISSION

NEGATIVE RESPONSE

TIME

REFERENCE
REPORTING TIME

REFERENCE
REPORTING TIME

CURRENT CYCLE

NEXT CYCLE

FIG.5

600

```
        ┌─────────────┐
        │    START    │
        └─────────────┘
               │
               ▼
┌─────────────────────────────────────────────┐
│  MEASURE BATTER DATA FROM PLURALITY OF BATTERY │ ～610
│   MODULES THROUGH PLURALITY OF IoT SENSORS     │
└─────────────────────────────────────────────┘
               │
               ▼
┌─────────────────────────────────────────────┐
│ PERFORM REPORTING TASK FOR BATTERY DATA ACCORDING TO │ ～620
│ DATA REPORTING POLICY THROUGH PLURALITY OF IoT SENSORS │
└─────────────────────────────────────────────┘
               │
               ▼
┌─────────────────────────────────────────────┐
│ DIAGNOSE STATES OF PLURALITY OF BATTERY MODULES BASED │ ～630
│    ON BATTERY DATA THROUGH MANAGEMENT SERVER   │
└─────────────────────────────────────────────┘
               │
               ▼
┌─────────────────────────────────────────────┐
│ ADJUST DATA REPORTING POLICY BASED ON STATES OF PLURALITY │ ～640
│  OF BATTERY MODULES AND RESULT OF REPORTING TASK │
│         THROUGH MANAGEMENT SERVER              │
└─────────────────────────────────────────────┘
               │
               ▼
        ┌─────────────┐
        │     END     │
        └─────────────┘
```

FIG.6

## INTERNATIONAL SEARCH REPORT

| International application No. |
|---|
| **PCT/KR2024/016580** |

| A. | CLASSIFICATION OF SUBJECT MATTER |
|---|---|
| | **G01R 31/385**(2019.01)i; **G01R 31/396**(2019.01)i; **G01R 31/371**(2019.01)i; **G16Y 40/10**(2020.01)i |

According to International Patent Classification (IPC) or to both national classification and IPC

| B. | FIELDS SEARCHED |
|---|---|

Minimum documentation searched (classification system followed by classification symbols)

G01R 31/385(2019.01); B60L 3/00(2006.01); B60L 50/50(2019.01); G01R 31/36(2006.01); G01R 31/396(2019.01); H01M 10/48(2006.01); H04L 12/24(2006.01); H04L 65/40(2022.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리 모듈(battery module), IoT 센서(IoT sensor), 상태(status), 진단(diagnosis), 서버(server)

| C. | DOCUMENTS CONSIDERED TO BE RELEVANT | |
|---|---|---|

| Category* | Citation of document, with indication, where appropriate, of the relevant passages | Relevant to claim No. |
|---|---|---|
| Y | KR 10-2020-0038269 A (NORTHSTAR BATTERY COMPANY, LLC) 10 April 2020 (2020-04-10)<br>See paragraphs [0005], [0015], [0033], [0036] and [0042]; claims 1 and 15; and figures 2a and 4a. | 1-2,6-10,14-16 |
| A | | 3-5,11-13 |
| Y | KR 10-2369656 B1 (LG UPLUS CORP.) 02 March 2022 (2022-03-02)<br>See paragraph [0026]; and figure 1. | 1-2,6-10,14-16 |
| Y | KR 10-2018-0029603 A (LG CHEM, LTD.) 21 March 2018 (2018-03-21)<br>See paragraphs [0044]-[0045]; and figure 1. | 7-8,15-16 |
| A | KR 10-2020-0080352 A (KOREA AUTOMOTIVE TECHNOLOGY INSTITUTE) 07 July 2020 (2020-07-07)<br>See paragraphs [0061]-[0065]; and figure 3. | 1-16 |

✓ Further documents are listed in the continuation of Box C.    ✓ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **05 February 2025** | **05 February 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

| International application No. |
|---|
| **PCT/KR2024/016580** |

**C. DOCUMENTS CONSIDERED TO BE RELEVANT**

| Category* | Citation of document, with indication, where appropriate, of the relevant passages | Relevant to claim No. |
|---|---|---|
| A | KR 10-2022-0129735 A (UC TECHNOLOGY CO., LTD. et al.) 26 September 2022 (2022-09-26)<br>See paragraphs [0029]-[0038]; and figure 1. | 1-16 |

Form PCT/ISA/210 (second sheet) (July 2022)

**EP 4 764 537 A1**

**INTERNATIONAL SEARCH REPORT**
Information on patent family members

International application No.

**PCT/KR2024/016580**

| Patent document cited in search report | | | Publication date (day/month/year) | Patent family member(s) | | | Publication date (day/month/year) |
|---|---|---|---|---|---|---|---|
| KR | 10-2020-0038269 | A | 10 April 2020 | CA | 3070566 | A1 | 31 January 2019 |
| | | | | CA | 3070569 | A1 | 31 January 2019 |
| | | | | CA | 3071116 | A1 | 31 January 2019 |
| | | | | CA | 3071118 | A1 | 31 January 2019 |
| | | | | CA | 3071121 | A1 | 31 January 2019 |
| | | | | CA | 3071122 | A1 | 31 January 2019 |
| | | | | CA | 3071124 | A1 | 31 January 2019 |
| | | | | CA | 3071126 | A1 | 31 January 2019 |
| | | | | CA | 3071141 | A1 | 31 January 2019 |
| | | | | CA | 3071146 | A1 | 31 January 2019 |
| | | | | CA | 3071148 | A1 | 31 January 2019 |
| | | | | CA | 3071151 | A1 | 31 January 2019 |
| | | | | CA | 3071154 | A1 | 31 January 2019 |
| | | | | CA | 3071157 | A1 | 31 January 2019 |
| | | | | CA | 3071666 | A1 | 31 January 2019 |
| | | | | CN | 111108401 | A | 05 May 2020 |
| | | | | CN | 111108402 | A | 05 May 2020 |
| | | | | CN | 111108404 | A | 05 May 2020 |
| | | | | CN | 111133325 | A | 08 May 2020 |
| | | | | CN | 111149007 | A | 12 May 2020 |
| | | | | CN | 111149008 | A | 12 May 2020 |
| | | | | CN | 111149009 | A | 12 May 2020 |
| | | | | CN | 111149010 | A | 12 May 2020 |
| | | | | CN | 111164435 | A | 15 May 2020 |
| | | | | CN | 111164439 | A | 15 May 2020 |
| | | | | CN | 111164440 | A | 15 May 2020 |
| | | | | CN | 111164441 | A | 15 May 2020 |
| | | | | CN | 111164821 | A | 15 May 2020 |
| | | | | CN | 111183461 | A | 19 May 2020 |
| | | | | CN | 111279557 | A | 12 June 2020 |
| | | | | EP | 3658932 | A1 | 03 June 2020 |
| | | | | EP | 3658933 | A1 | 03 June 2020 |
| | | | | EP | 3658934 | A1 | 03 June 2020 |
| | | | | EP | 3658935 | A2 | 03 June 2020 |
| | | | | EP | 3658935 | B1 | 29 November 2023 |
| | | | | EP | 3658936 | A1 | 03 June 2020 |
| | | | | EP | 3658937 | A1 | 03 June 2020 |
| | | | | EP | 3658937 | B1 | 24 July 2024 |
| | | | | EP | 3658938 | A2 | 03 June 2020 |
| | | | | EP | 3658939 | A1 | 03 June 2020 |
| | | | | EP | 3658939 | B1 | 11 May 2022 |
| | | | | EP | 3658940 | A1 | 03 June 2020 |
| | | | | EP | 3658941 | A1 | 03 June 2020 |
| | | | | EP | 3658942 | A2 | 03 June 2020 |
| | | | | EP | 3658942 | B1 | 17 August 2022 |
| | | | | EP | 3658943 | A1 | 03 June 2020 |
| | | | | EP | 3659129 | A1 | 03 June 2020 |
| | | | | EP | 3659203 | A1 | 03 June 2020 |
| | | | | EP | 3659218 | A1 | 03 June 2020 |
| | | | | EP | 3659218 | B1 | 19 July 2023 |

Form PCT/ISA/210 (patent family annex) (July 2022)

19

## INTERNATIONAL SEARCH REPORT
### Information on patent family members

| International application No. |
| --- |
| **PCT/KR2024/016580** |

| Patent document cited in search report | Publication date (day/month/year) | Patent family member(s) | | | Publication date (day/month/year) |
| --- | --- | --- | --- | --- | --- |
| | | ES | 2924278 | T3 | 05 October 2022 |
| | | ES | 2929534 | T3 | 30 November 2022 |
| | | ES | 2959527 | T3 | 26 February 2024 |
| | | ES | 2970610 | T3 | 29 May 2024 |
| | | ES | 2987535 | T3 | 15 November 2024 |
| | | JP | 2020-528981 | A | 01 October 2020 |
| | | JP | 2020-529020 | A | 01 October 2020 |
| | | JP | 2020-529021 | A | 01 October 2020 |
| | | JP | 2020-529022 | A | 01 October 2020 |
| | | JP | 2020-529024 | A | 01 October 2020 |
| | | JP | 2020-529104 | A | 01 October 2020 |
| | | JP | 2020-529107 | A | 01 October 2020 |
| | | JP | 2020-529108 | A | 01 October 2020 |
| | | JP | 2020-529109 | A | 01 October 2020 |
| | | JP | 2020-529110 | A | 01 October 2020 |
| | | JP | 2020-529111 | A | 01 October 2020 |
| | | JP | 2020-529112 | A | 01 October 2020 |
| | | JP | 2020-529114 | A | 01 October 2020 |
| | | JP | 2020-529662 | A | 08 October 2020 |
| | | JP | 2020-529663 | A | 08 October 2020 |
| | | KR | 10-2020-0024332 | A | 06 March 2020 |
| | | KR | 10-2020-0024358 | A | 06 March 2020 |
| | | KR | 10-2020-0024359 | A | 06 March 2020 |
| | | KR | 10-2020-0024944 | A | 09 March 2020 |
| | | KR | 10-2020-0027039 | A | 11 March 2020 |
| | | KR | 10-2020-0032739 | A | 26 March 2020 |
| | | KR | 10-2020-0036893 | A | 07 April 2020 |
| | | KR | 10-2020-0038264 | A | 10 April 2020 |
| | | KR | 10-2020-0038265 | A | 10 April 2020 |
| | | KR | 10-2020-0038267 | A | 10 April 2020 |
| | | KR | 10-2020-0049770 | A | 08 May 2020 |
| | | KR | 10-2020-0049771 | A | 08 May 2020 |
| | | KR | 10-2020-0049772 | A | 08 May 2020 |
| | | KR | 10-2020-0050455 | A | 11 May 2020 |
| | | US | 10627451 | B2 | 21 April 2020 |
| | | US | 10684330 | B2 | 16 June 2020 |
| | | US | 10816607 | B2 | 27 October 2020 |
| | | US | 10823786 | B2 | 03 November 2020 |
| | | US | 10830826 | B2 | 10 November 2020 |
| | | US | 10830827 | B2 | 10 November 2020 |
| | | US | 10921381 | B2 | 16 February 2021 |
| | | US | 11243260 | B2 | 08 February 2022 |
| | | US | 11300624 | B2 | 12 April 2022 |
| | | US | 2019-0033377 | A1 | 31 January 2019 |
| | | US | 2019-0033381 | A1 | 31 January 2019 |
| | | US | 2019-0033382 | A1 | 31 January 2019 |
| | | US | 2019-0033383 | A1 | 31 January 2019 |
| | | US | 2019-0033384 | A1 | 31 January 2019 |
| | | US | 2019-0033385 | A1 | 31 January 2019 |
| | | US | 2019-0033388 | A1 | 31 January 2019 |

Form PCT/ISA/210 (patent family annex) (July 2022)

## INTERNATIONAL SEARCH REPORT
### Information on patent family members

| International application No. |
|---|
| **PCT/KR2024/016580** |

| Patent document cited in search report | Publication date (day/month/year) | Patent family member(s) | | Publication date (day/month/year) |
|---|---|---|---|---|
| | | US | 2019-0033393 A1 | 31 January 2019 |
| | | US | 2019-0033394 A1 | 31 January 2019 |
| | | US | 2019-0033395 A1 | 31 January 2019 |
| | | US | 2019-0033396 A1 | 31 January 2019 |
| | | US | 2019-0033397 A1 | 31 January 2019 |
| | | US | 2019-0035237 A1 | 31 January 2019 |
| | | US | 2019-0036178 A1 | 31 January 2019 |
| | | US | 2021-0376396 A1 | 02 December 2021 |
| | | US | 2022-0404426 A1 | 22 December 2022 |
| | | WO | 2019-023629 A2 | 31 January 2019 |
| | | WO | 2019-023629 A3 | 07 March 2019 |
| | | WO | 2019-023656 A1 | 31 January 2019 |
| | | WO | 2019-023663 A1 | 31 January 2019 |
| | | WO | 2019-023666 A1 | 31 January 2019 |
| | | WO | 2019-023670 A1 | 31 January 2019 |
| | | WO | 2019-023671 A1 | 31 January 2019 |
| | | WO | 2019-023672 A1 | 31 January 2019 |
| | | WO | 2019-023673 A1 | 31 January 2019 |
| | | WO | 2019-023675 A1 | 31 January 2019 |
| | | WO | 2019-023678 A1 | 31 January 2019 |
| | | WO | 2019-023679 A1 | 31 January 2019 |
| | | WO | 2019-023681 A1 | 31 January 2019 |
| | | WO | 2019-023682 A2 | 31 January 2019 |
| | | WO | 2019-023682 A3 | 28 February 2019 |
| | | WO | 2019-023684 A1 | 31 January 2019 |
| | | WO | 2019-023687 A2 | 31 January 2019 |
| | | WO | 2019-023687 A3 | 07 March 2019 |
| KR 10-2369656 B1 | 02 March 2022 | None | | |
| KR 10-2018-0029603 A | 21 March 2018 | KR | 10-1945426 B1 | 07 February 2019 |
| | | US | 10317471 B2 | 11 June 2019 |
| | | US | 2018-0074135 A1 | 15 March 2018 |
| KR 10-2020-0080352 A | 07 July 2020 | KR | 10-2166092 B1 | 15 October 2020 |
| KR 10-2022-0129735 A | 26 September 2022 | KR | 10-2622789 B1 | 10 January 2024 |

Form PCT/ISA/210 (patent family annex) (July 2022)

**EP 4 764 537 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230171978